# EUROPEAN PATENT SPECIFICATION

(11) **EP 3 301 667 B1**
(45) Date of publication and mention of the grant of the patent: **05.12.2018**
(21) Application number: 17192280.0
(22) Date of filing: 21.09.2017
(51) Int. Cl.: G09G 3/36, G06F 3/041, G11C 19/00

(54) **TOUCH SENSOR INTEGRATED TYPE DISPLAY DEVICE**
ANZEIGEVORRICHTUNG MIT INTEGRIERTEM BERÜHRUNGSSENSOR
DISPOSITIF D'AFFICHAGE INTÉGRÉ À CAPTEUR TACTILE

(30) Priority: 30.09.2016 KR 20160127120
(43) Date of publication of application: 04.04.2018
(73) Proprietor: LG Display Co., Ltd., Seoul, 07336 (KR)
(72) Inventor: So, Byeongseong, 10845 Gyeonggi-do (KR); Kwon, Kitae, 10845 Gyeonggi-do (KR); Kim, Kyujin, 10845 Gyeonggi-do (KR); Cho, Seungwan, 10845 Gyeonggi-do (KR)
(74) Representative: Ter Meer Steinmeister & Partner

(56) References cited:
- EP-A1- 3 051 531
- WO-A1-2015/137706
- US-A1- 2010 156 862

## Description

### BACKGROUND OF THE INVENTION

### Field of the Invention

The present disclosure relates to a touch sensor integrated type display device.

### Discussion of the Related Art

Flat panel displays (hereinafter referred to as "display devices"), which are able to be manufactured as large-sized display devices at a low price and excellent in display quality (including motion picture representation, resolution, brightness, contrast ratio, color representation, etc.), have been recently actively developed in accordance with the need for display devices capable of properly displaying multimedia together with the development of multimedia. Various input devices, such as a keyboard, a mouse, a track ball, a joystick, and a digitizer, have been used in the display devices to allow users to interface with the display devices. However, when the user makes use of these input devices, the user's dissatisfaction increases because the user is required to learn how to use the input devices and the input devices occupy space, thereby having difficulty in increasing the perfection of products. Thus, a demand for a convenient and simple input device for the display device capable of reducing erroneous operations is increasing. In response to the increased demand, a touch sensor has been proposed to recognize information when the user inputs information by directly touching the screen or approaching the screen with his or her hand or a pen while he or she watches the display device.

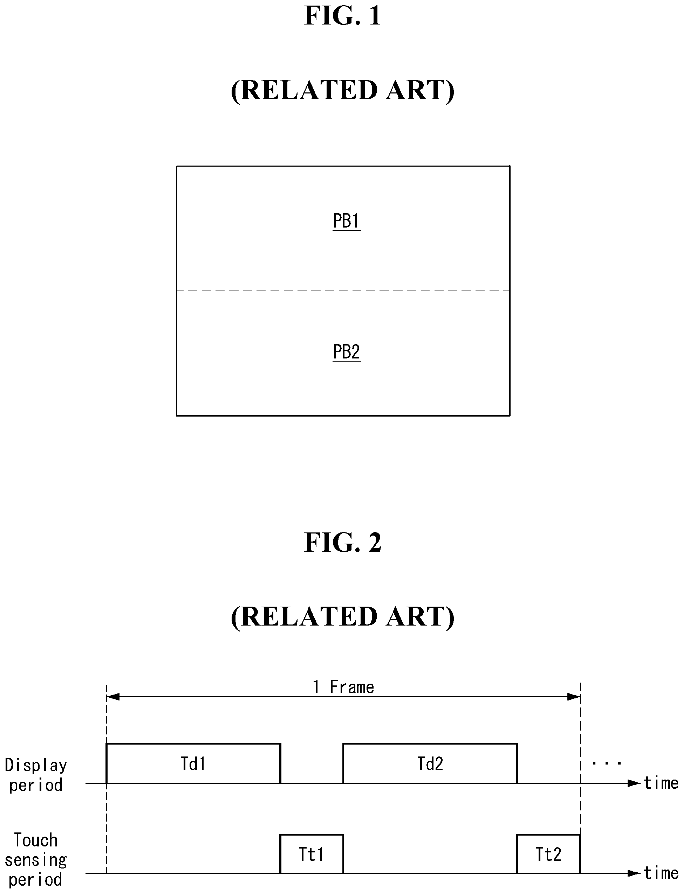

The touch sensors used in the display device may be implemented through an in-cell technology in which they are embedded inside a display panel. In a display device using in-cell technology a touch electrode of a touch sensor may be shared with a common electrode of the display panel with each other and one frame may be divided into a display period and a touch sensing period. In particular, as shown in FIG. 1, a display panel may be divided into a plurality of panel blocks PB1 and PB2, and a display drive and a touch sensing drive may be performed on each of the panel blocks PB1 and PB2. For example, data of an input image is written to pixels of the first panel block PB1 during a first display period Td1, and then touch sensors are driven to sense a touch input during a first touch sensing period Tt1. Subsequently, data of the input image is written to pixels of the second panel block PB2 during a second display period Td2, and then the touch sensors are driven to sense a touch input during a second touch sensing period Tt2.

During a display period, a gate driver sequentially shifts a gate pulse applied to gate lines using a shift register. The gate pulse sequentially selects pixels to be charged with a data signal in synchronization with the data signal of the input image on a per line basis. The shift register of the gate driver includes cascade-connected stages. The cascade-connected stages of the shift register each receive a start pulse or an output of a preceding stage and charge a Q node.

However, as shown in FIG. 2, when the display period is divided based on the number of blocks and the touch sensing period is allocated between the divided display periods, a line dim phenomenon appears on a first line, at which the display period again starts immediately after the touch sensing period.
EP 3 051 531 A1 describes a display device having a shift register. The stages of the shift register are driven in the order of B, C (dummy stage) and A during forward driving operation and in the order of A, C (dummy stage) and B during reverse driving operation. In forward driving operation, B is a stage outputting the last gate pulse prior to touch operation, C is a dummy stage which holds charging state of a Q node thereof during a touch time, and A is a stage outputting the first gate pulse after completion of the touch operation. In reverse driving operation, A is a stage outputting the last gate pulse prior to the touch operation, C is a dummy stage which holds charging state of a Q node thereof during the touch time, and B is a stage outputting the first gate pulse after completion of the touch operation.

### SUMMARY OF THE INVENTION

It is an object of the invention to avoid that line dim phenomenon. Said object has been addressed with the subject matter of the independent claims. Advantageous embodiments are described in the dependent claims.

It is proposed a shift register for a display panel, preferably comprising a first stage group comprising a last stage, wherein the last stage is configured for transmitting a gate pulse to a gate line of the display panel; a bridge stage configured for receiving the gate pulse from the last stage, and transmitting a first carry signal; and a second stage group comprising a first stage, wherein the first stage is configured for receiving the first carry signal.

According to an embodiment a shift register is proposed, wherein the last stage is configured for transmitting the gate pulse in response to the potential of a Q node of the last stage and a clock signal; wherein the bridge stage is configured for charging a Q node of the bridge stage in response to the gate pulse and transmitting the first carry signal in response to the potential of the Q node and a bridge clock; and wherein the first stage is configured for charging a Q node of the first stage of the second stage group.

Due to the dedicated bridge stage of the proposed shift register, all the stages of the shift register which transmit a gate pulse to a gate line of the display panel may have the same Q node charging period (hereinafter, referred to as "Q standby period") of about two horizontal periods.

In case of a full high definition (FHD) display device, one horizontal period may be about 6.0 µs, and a touch sensing period may be about 100 µs. A Q node of the stage of the proposed shift register, which stage generates the first gate pulse immediately after the touch sensing period, is not discharged for the approximately 100 µs of the touch sensing period and accordingly does not generate a low output. Thus, a Q standby period of a stage, that generates a first output immediately after the touch sensing period, is not about 100 µs or more, but essentially equal to a Q standby period of other stages of the shift register of about 12.0 µs.

In an embodiment, the first stage is configured for transmitting a gate pulse to a gate line of the display panel in response to the potential of the Q node of the first stage of the second stage group and a clock signal; and the bridge stage is configured for receiving the gate pulse from the first stage; discharging the Q node of the bridge stage in response to the gate pulse.

In an embodiment, it is proposed a shift register, wherein at least one of the last stage of the first stage group, the first stage of the second stage group and the bridge stage comprises a pull-up transistor, a pull-down transistor, a first transistor, a third transistor, a fifth transistor, and a sixth transistor; wherein a drain electrode of the first transistor is connected to a high potential voltage; wherein a source electrode of the first transistor is connected to the Q node; wherein a gate electrode of the first transistor is connected to terminal Vst; wherein a drain electrode of the third transistor is connected to the Q node; wherein a source electrode of the third transistor is connected to the low potential voltage; wherein a gate electrode of the third transistor is connected to a source of the fifth transistor; wherein a source of the fifth transistor is connected to the low potential voltage; wherein a gate of the fifth transistor is connected to a terminal Vst; wherein a drain of the sixth transistor is connected to the gate of third transistor; wherein a source of the sixth transistor is connected to the low potential voltage; wherein a gate of the sixth transistor is connected to the drain of the first transistor; wherein a drain of the pull-up transistor is connected to the block clock; wherein a source of the pull-up transistor is connected to a source of the pull-down transistor; wherein a gate of the pull-up transistor is connected to the Q node; wherein the source of the pull-down transistor is connected to the low potential voltage; wherein the gate of the pull-down transistor is connected to the gate of the third transistor; and wherein the drain of the fifth transistor is connected to the gate of the third transistor.

In an embodiment, it is proposed a shift register, wherein the last stage of the first stage group, first stage of the second stage group or bridge stage comprises a second transistor, a fourth transistor; wherein a source of the second transistor is connected to the Q node; wherein a drain of the second transistor is connected to a low potential voltage; wherein a gate of the second transistor is connected to a terminal Vnext; wherein a source of the fourth transistor is connected to the gate of the third transistor; wherein a drain of the fourth transistor is connected to the high potential voltage; wherein a gate of the fourth transistor is connected to a terminal Vnext.

In an embodiment, it is proposed a shift register, wherein the bridge stage comprises a pull-up transistor, a pull-down transistor, a first transistor, a third transistor, a fifth transistor, a sixth transistor; wherein a drain electrode of the first transistor is connected to a high potential voltage; wherein a source electrode of the first transistor is connected to the Q node; wherein a gate electrode of the first transistor is connected to a terminal Vst; wherein a drain electrode of the third transistor is connected to the Q node; wherein a source electrode of the third transistor is connected to the low potential voltage; wherein a gate electrode of the third transistor is connected to a source of the fifth transistor; wherein a source of the fifth transistor is connected to the low potential voltage; wherein a gate of the fifth transistor is connected to a terminal Vst; wherein a drain of the sixth transistor is connected to the gate of third transistor; wherein a source of the sixth transistor is connected to the low potential voltage; wherein a gate of the sixth transistor is connected to the drain of the first transistor; wherein a drain of the pull-up transistor is connected to the block clock; wherein a source of the pull-up transistor is connected to a source of the pull-down transistor; wherein a gate of the pull-up transistor is connected to the Q node; wherein the source of the pull-down transistor is connected to the low potential voltage; wherein the gate of the pull-down transistor is connected to the gate of the third transistor; wherein the source of the fifth transistor is connected to the Q node; wherein the source of the second pull-up transistor is connected to a second block clock; wherein the drain of the second pull-up transistor is connected to the source of the pull-down transistor; and wherein the gate of the second pull-up transistor is connected to the Q node.

In an embodiment, it is proposed a shift register, wherein the bridge stage comprises a second transistor, a fourth transistor; wherein a source of the second transistor is connected to the Q node; wherein a drain of the second transistor is connected to a low potential voltage; wherein a gate of the second transistor is connected to a terminal Vnext; wherein a source of the fourth transistor is connected to the gate of the third transistor; wherein a drain of the fourth transistor is connected to a second high potential voltage; and wherein a gate of the fourth transistor is connected to a terminal Vnext.

In another aspect, it is proposed a gate driver comprising an aforementioned shift register and a level shifter for shifting transistor-transistor-logic, TTL, voltages of gate clocks to a gate high voltage and a gate low voltage.

According to a further aspect, it is proposed a display panel comprising a display unit including a plurality of pixels and at least one touch sensor, an aforementioned gate driver for transmitting gate pulses to gate lines of the display unit, and a touch sensing circuit.

In an embodiment, it is proposed a display panel, wherein the touch sensor is formed by a common electrode of a group of the plurality of pixels.

According to another aspect, it is proposed a method for driving a display panel, wherein the display panel comprises a gate driver including a shift register and a touch sensing circuit; wherein the shift register comprises a first stage group comprising a last stage, a bridge stage, a second stage group comprising a first stage; and wherein the method comprises receiving a gate pulse by the bridge stage from the last stage; sensing a touch by the touch sensing circuit after receiving the gate pulse by the bridge stage; and transmitting a first carry signal from the bridge stage to the first stage after sensing the touch.

In an embodiment, the method further comprises charging a Q node of the bridge stage in response to the gate pulse; and transmitting the first carry signal in response to the potential of the Q node and a bridge clock.

In an embodiment, the method further comprises discharging the Q node of the bridge stage in response to a gate pulse received from the first stage.

In an embodiment, it is proposed a method, wherein sensing the touch by the touch sensing circuit comprises using touch sensors formed by a common electrode of a group of pixels of a display unit of the display panel.

In an embodiment, an aforementioned shift register is used.

In one aspect, there is provided a touch sensor integrated type display device including a display panel including first and second panel blocks, each of the first and second panel blocks including a pixel array in which touch sensors are embedded; a display driving circuit configured to write image data to pixels of each of the first and second panel blocks during a display period; and a touch sensing circuit configured to drive the touch sensors of each of the first and second panel blocks during a touch sensing period, wherein the display driving circuit includes a shift register configured to sequentially output gate pulses applied to gate lines, wherein the shift register includes a first stage group configured to apply a gate pulse to gate lines arranged in the first panel block; a bridge stage connected to a last stage of the first stage group in cascade and configured to output a first carry signal; and a second stage group configured to apply a gate pulse to gate lines arranged in the second panel block, wherein a first stage of the second stage group operates in response to the first carry signal.

In an embodiment, the bridge stage includes: a first transistor including a gate electrode connected to a start signal input terminal, a drain electrode connected to a high potential voltage input terminal, and a source electrode connected to a Q node; and a first pull-up transistor configured to output the first carry signal using a first bridge clock applied to a drain electrode in response to a voltage of the Q node, wherein the first bridge clock is applied before the first stage of the second stage group outputs the gate pulse in the display period in which an image is displayed on the pixels of the second panel block.

In an embodiment, the start signal input terminal of the bridge stage receives the gate pulse output by the last stage of the first stage group.

In an embodiment, each of stages included in each of the first and second stage groups includes: a start control transistor configured to charge a Q1 node to a high potential voltage in response to a voltage of the start signal input terminal; and a pull-up transistor configured to output the gate pulse using a gate clock applied to a drain electrode in response to a voltage of the Q1 node, wherein the first carry signal is applied to a gate electrode of the start control transistor included in the first stage of the second stage group.

In an embodiment, the bridge stage further includes a second pull-up transistor configured to output a second carry signal using a second bridge clock applied to a drain electrode in response to the voltage of the Q node, and the second bridge clock is applied after the last stage of the first stage group outputs the gate pulse in the display period in which an image is displayed on the pixels of the first panel block.

In an embodiment, each of the stages included in each of the first and second stage groups further includes a Q node control transistor configured to discharge the Q1 node to a low potential voltage in response to a voltage of a next signal input terminal, and the second carry signal is applied to a gate electrode of the Q node control transistor included in the last stage of the first stage group.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIGS. 1 and 2 illustrate a display drive and a touch sensing drive on a per block basis in accordance with a related art;
FIG. 3 illustrates a display device according to an exemplary embodiment;
FIG. 4 is a plan view of a pixel array according to an exemplary embodiment;
FIG. 5 illustrates timing of a touch sync signal and timing of a common voltage;
FIG. 6 illustrates configuration of a shift register according to an exemplary embodiment;
FIG. 7 illustrates stages of a shift register according to an exemplary embodiment;
FIG. 8 illustrates a bridge stage according to a first example not forming part of the present invention;
FIG. 9 is a timing diagram illustrating output signals of stages shown in FIG. 8;
FIG. 10 illustrates a shift register according to a comparative example;
FIG. 11 is a timing diagram illustrating output signals of a shift register shown in FIG. 10;
FIG. 12 illustrates a bridge stage according to a first embodiment of the present invention;
FIG. 13 illustrates a shift register to which a bridge stage shown in FIG. 12 is applied; and
FIG. 14 is a timing diagram illustrating output signals of stages shown in FIG. 12.

### DETAILED DESCRIPTION OF THE EMBODIMENTS

Reference will now be made in detail to embodiments of the present disclosure, examples of which are illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Switching elements of a gate driver according to embodiments may be implemented as transistors of n-type or p-type metal oxide semiconductor field effect transistor (MOSFET) structure. In embodiments disclosed herein, n-type transistors are described by way of example. However, embodiments are not limited thereto, and other types of transistors may be used. The transistor is a three-electrode element including a gate, a source, and a drain. The source is an electrode for supplying carriers to the transistor. The carriers inside the transistor begin to flow from the source. The drain is an electrode from which the carriers exit the transistor. Namely, carriers in the MOSFET flow from the source to the drain. In case of an n-type MOSFET (NMOS), because carriers are electrons, a source voltage is less than a drain voltage so that electrons can flow from a source to a drain. In the n-type MOSFET, because electrons flow from the source to the drain, a current flows from the drain to the source. In case of a p-type MOSFET (PMOS), because carriers are holes, a source voltage is greater than a drain voltage so that holes can flow from a source to a drain. In the p-type MOSFET, because holes flow from the source to the drain, a current flows from the source to the drain. In embodiments disclosed herein, the source and the drain of the MOSFET are not fixed. For example, the source and the drain of the MOSFET may be changed depending on an applied voltage. The following embodiments are limited to the source and the drain of the transistor.

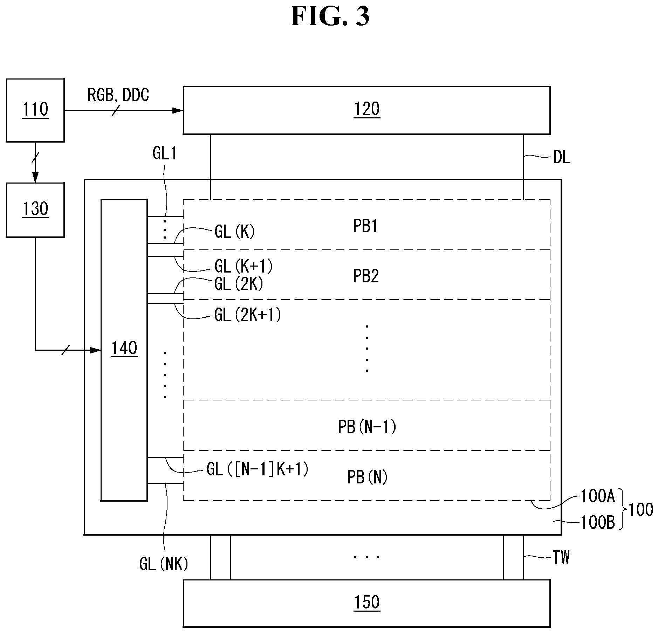

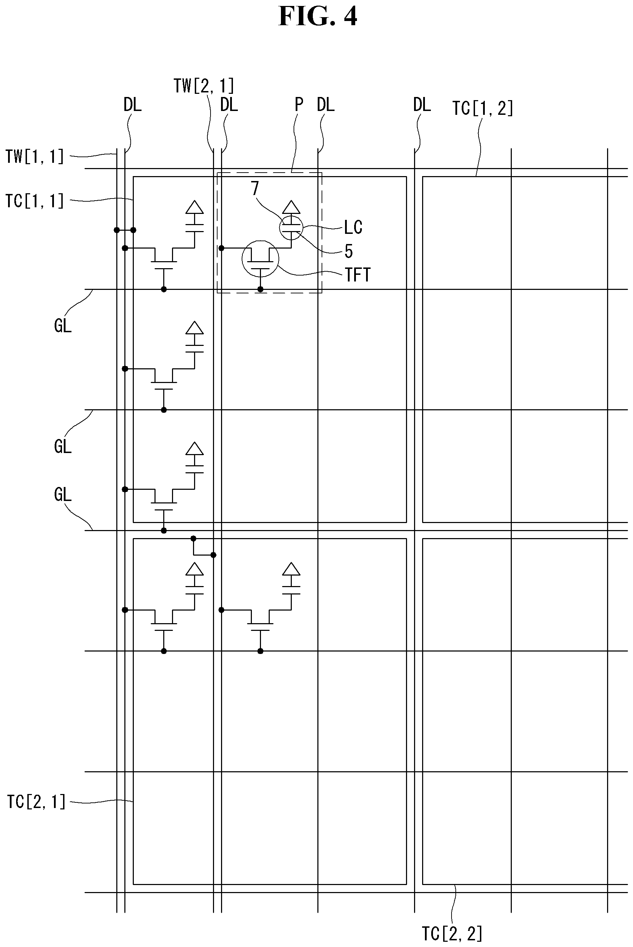

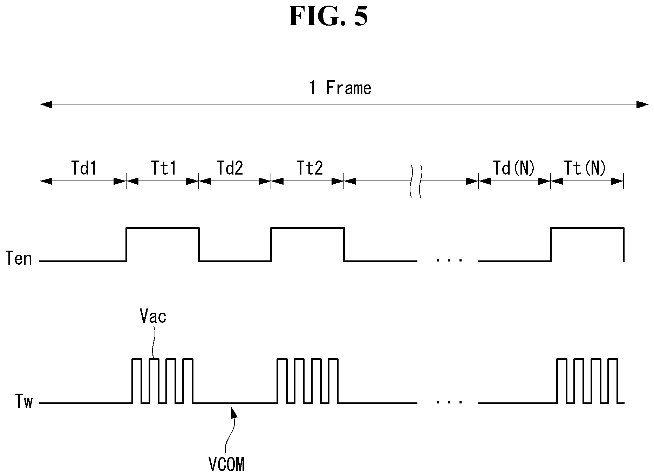

FIG. 3 illustrates a touch sensor integrated type display device according to an exemplary embodiment. FIG. 4 illustrates pixels included in a touch senor according to an exemplary embodiment. FIG. 5 illustrates signals output to signal lines by a driving circuit. In FIGS. 3 and 4, the respective touch sensors and the respective sensing lines are designated with indices in square brackets indicating their position. However, in the following description, the touch sensors and the sensing lines will be commonly referred to as a touch sensor TC and a sensing line TW when they are described without distinguishing their positions.

Referring to FIGS. 3 to 5, a touch sensor integrated type display device according to an exemplary embodiment includes a display panel 100, a timing controller 110, a data driver 120, a level shifter 130, a shift register 140, and a touch sensing circuit 150.

The display panel 100 includes a display unit 100A and a non-display unit 100B. The display unit 100A includes pixels P for displaying image information and touch sensors TC. The non-display unit 100B may be provided separately from the display unit 100A, in particular outside of the area occupied by the display unit 100A.

The display unit 100A is divided into N panel blocks PB1 to PB(N). Each of the panel blocks PB1 to PB(N) displays an image and performs a touch sensing drive. Further, each of the panel blocks PB1 to PB(N) includes k pixel lines, where k is a natural number. Each pixel line is connected to first to k-th gate lines, for example the pixel lines of the panel block PB1 may be connected to the first to k-th gate lines GL1 to GL(k).

A pixel array of the display panel 100 includes data lines DL, gate lines GL, thin film transistors TFT formed at crossings of the data lines DL and the gate lines GL, pixel electrodes 5 connected to the thin film transistors TFT, and storage capacitors (not shown) connected to the pixel electrodes 5, and the like. The thin film transistor TFT is turned on in response to a gate pulse from the gate line GL and supplies a data voltage, that is applied through the data line DL, to the pixel electrode 5. A liquid crystal layer LC is driven by a voltage difference between the data voltage charged to the pixel electrode 5 and a common voltage Vcom applied to a common electrode 7 and controls an amount of light transmitted.

The touch sensors TC are connected to the plurality of pixels P and are implemented as capacitive touch sensors to sense a touch input. Each touch sensor TC may be assigned to a group of the plurality of pixels P. FIG. 4 illustrates that nine pixels P arranged in a 3x3 matrix are assigned to one touch sensor TC by way of example. The common electrode 7 may be divided to form separate common electrodes assigned to the groups of the plurality of pixels P. Thus, an area occupied by a separate common electrode 7 may be referred to as the touch sensor TC. The touch sensors TC are respectively connected to sensing lines TW. For example, a sensing line TW[1, 1] of a first row and a first column is connected to a touch sensor TC[1, 1] of the first row and the first column, and a sensing line TW[1, 2] of the second row and a first column is connected to a touch sensor TC[1, 2] of the second row and the first column.

The common electrode 7 receives a reference voltage (i.e., the common voltage Vcom) of the pixels P during a display period and receives a touch sensing signal Vac during a touch sensing period.

The non-display unit 100B may be disposed outside the area of the display unit 100A, and may comprise a driving circuit IC for driving the data lines DL and the gate lines GL.

A display driving circuit includes the data driver 120 and the gate drivers 130 and 140 and writes data of an input image to the pixels P of the display panel 100. The display driving circuit time-divides one frame period into a plurality of display periods and a plurality of touch sensing periods and writes the data of the input image to the pixels P on a per block basis in the display period. As shown in FIG. 5, one frame includes N display periods Td1 to Td(N) and N touch sensing periods Tt1 to Tt(N). The display periods Td1 to Td(N) and the touch sensing periods Tt1 to Tt(N) alternate with each other. During the first display period Td1, image data is written to a first panel block PB1. During the first touch sensing period Tt1, the touch sensors TC inside the first panel block PB1 are driven.

The data driver 120 receives image data from the timing controller 110 and converts the image data into positive and negative gamma compensation voltages to output positive and negative data voltages. The data driver 120 then supplies the positive and negative data voltages to the data lines DL.

A gate driver sequentially supplies the gate pulses to the gate lines GL under the control of the timing controller 110. The gate pulse output from the gate driver is synchronized with the data voltage. The gate driver may include a level shifter 130 and a shift register 140 which are connected between the timing controller 110 and the gate lines of the display panel 100. The level shifter 130 level-shifts transistor-transistor-logic (TTL) level voltages of gate clocks CLK input from the timing controller 110 to a gate high voltage VGH and a gate low voltage VGL. The shift register 140 includes stages which shift a start signal VST in accordance with the gate clock CLK and sequentially output gate pulses Gout.

The timing controller 110 transmits data of an input image received from a host system (not shown) to the data driver 120. The timing controller 110 receives timing signals, such as a vertical sync signal Vsync, a horizontal sync signal Hsync, a data enable signal DE, and a main clock MCLK, from the host system in synchronization with the data of the input image. The timing controller 110 generates a data timing control signal for controlling operation timing of the data driver 120 and a gate timing control signal for controlling operation timing of the gate driver based on the timing signals. The timing controller 110 synchronizes the display driving circuit with the touch sensing circuit 150.

The touch sensing circuit 150 drives the touch sensors TC in response to a touch enable signal Ten received from the timing controller 110 or the host system during the touch sensing period. The touch sensing circuit 150 supplies the touch driving signal Vac to the touch sensors TC through the sensor lines TW to sense a touch input during the touch sensing period. The touch sensing circuit 150 analyzes a change amount of charges of the touch sensor, which varies depending on the presence or absence of a touch input, and determines the touch input. The touch sensing circuit 150 calculates coordinates of a position of the touch input and transmits coordinate information of the touch input position to the host system.

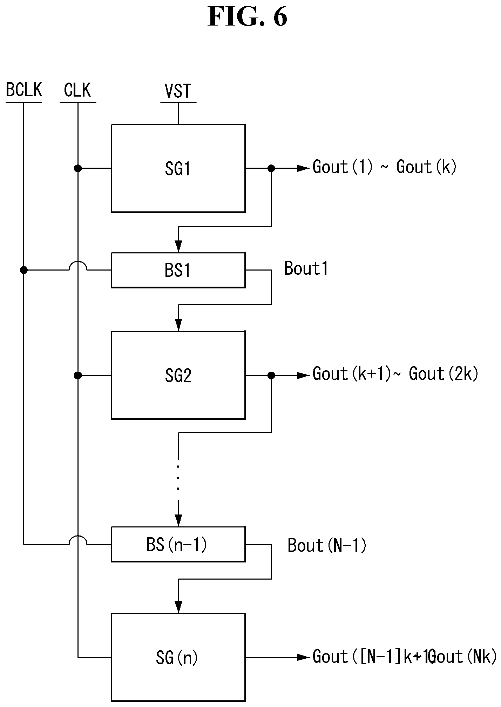

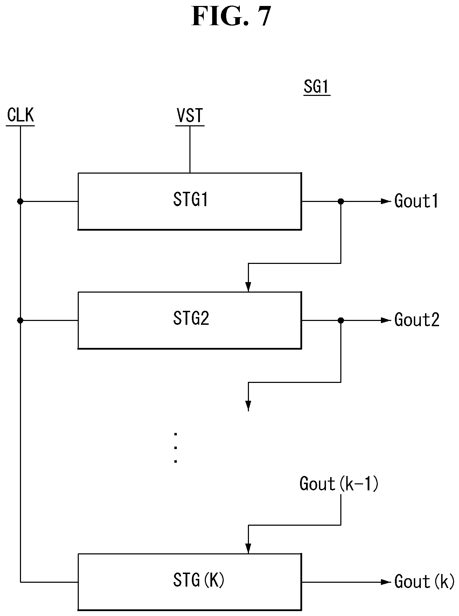

FIG. 6 illustrates configuration of a shift register according to an exemplary embodiment. FIG. 7 illustrates stages of a first shift register shown in FIG. 6. In the following description, "preceding stage" is a stage positioned ahead of a reference stage and "subsequent stage" is a stage positioned behind the reference stage. For example, when an i-th stage STG(i) is determined as a reference stage, where "i" is a natural number less than "N×k", the preceding stage is the stage STG(i-1) and the subsequent stage is the stage STG(i+1).

Referring to FIGS. 6 and 7, a shift register according to the embodiment includes first to Nth stage groups SG1 to SG(N) and first to (N-1)th bridge stages BS1 to BS(N-1).

A j-th stage group SG(j) applies a gate pulse to the gate lines belonging to a j-th panel block PBj, where j is a natural number equal to or less than N. The first to Nth stage groups SG1 to SG(N) each include k stages for outputting k gate pulses. For example, the first stage group SG1 includes first to k-th stages STG1 to STG(k).

In the first stage group SG1, output signals of the first to k-th stages STG1 to STG(k) are carry signals applied to a subsequent stage. For example, a first gate pulse Gout1 is applied to the second stage STG2, and a (k-1)th gate pulse Gout(k-1) is applied to the k-th stage STG(k). Then, a k-th gate pulse Gout(k) is applied to a first bridge stage BS1.

The first to (N-1)th bridge stages BS1 to BS(N-1) are positioned between the first to Nth stage groups SG1 to SG(N) and output a first carry signal Bout1 to Bout(N-1). The first carry signal is applied to a first transistor T1 of a subsequent stage. For example, the first carry signal Bout1 output from the first bridge stage BS1 is applied to a first stage STG(k+1) of the second stage group SG2.

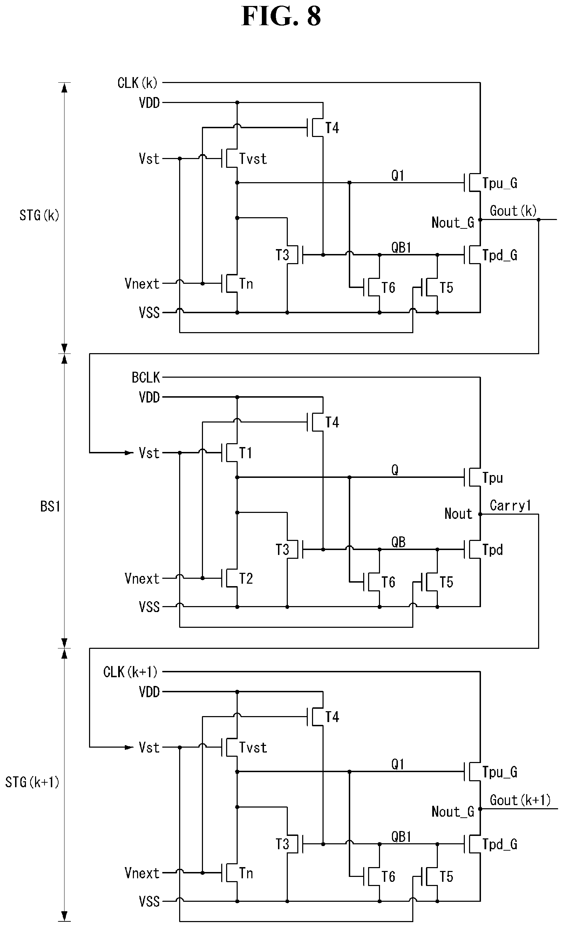

FIG. 8 illustrates a bridge stage according to a first example not forming part of the present invention. The stages of the stage groups SG1 to SG(n) and the bridge stages BS1 to BS(n-1) according to the first example may be implemented with the same circuit. The configuration of the stages of the stage groups are denoted by reference numerals denoted by parentheses, in order to distinguish it from the configuration of the bridge stages. A first transistor of the stage groups is referred to as a start control transistor, and a second transistor of the stage groups is referred to as a Q node control transistor.

Referring to FIG. 8, a bridge stage BS includes a pull-up transistor Tpu, a pull-down transistor Tpd, and first to sixth transistors T1 to T6.

The pull-up transistor Tpu includes a gate electrode connected to a Q node, a drain electrode receiving a bridge clock BCLK, and a source electrode connected to an output terminal Nout. As a result, the pull-up transistor Tpu outputs a first carry signal Carry1 in response to a voltage of the Q node during an application of the bridge clock BCLK.

The pull-down transistor Tpd includes a gate electrode connected to a QB node, a drain electrode connected to the output terminal Nout, and a source electrode connected to an input terminal of a low potential voltage VSS. The pull-down transistor Tpd discharges a voltage of the output terminal Nout to the low potential voltage VSS in response to a voltage of the QB node.

The first transistor T1 includes a gate electrode connected to a start signal input terminal VST, a drain electrode connected to an input terminal of a high potential voltage VDD, and a source electrode connected to the Q node. The start signal input terminal VST receives a gate pulse Gout(i-1) of a preceding stage. For example, the start signal input terminal VST of the first bridge stage BS1 receives the k-th gate pulse Gout(k). The first transistor T1 charges the Q node in accordance with a voltage of the start signal input terminal VST.

The second transistor T2 includes a gate electrode connected to a next signal input terminal VNEXT, a drain electrode connected to the Q node, and a source electrode connected to the input terminal of the low potential voltage VSS. The next signal input terminal VNEXT receives a gate pulse of a subsequent stage. For example, a next signal input terminal VNEXT of the first bridge stage BS1 receives a (k+1)th gate pulse Gout(k+1). The second transistor T2 discharges the Q node to the low potential VSS in response to a voltage of the next signal input terminal VNEXT.

The third transistor T3 includes a gate electrode connected to the QB node, a drain electrode connected to the Q node, and a source electrode connected to the input terminal of the low potential voltage VSS. The third transistor T3 discharges the voltage of the Q node to the low potential voltage VSS when the QB node is charged.

The fourth transistor T4 includes a gate electrode connected to the next signal input terminal VNEXT, a drain electrode connected to the input terminal of the high potential voltage VDD, and a source electrode connected to the QB node. The fourth transistor T4 charges the QB node to the high potential voltage VDD in response to the voltage of the next signal input terminal VNEXT.

The fifth transistor T5 includes a gate electrode connected to the start signal input terminal VST, a drain electrode connected to the QB node, and a source electrode connected to the input terminal of the low potential voltage VSS. The fifth transistor T5 discharges the QB node to the low potential voltage VSS in response to the voltage of the start signal input terminal VST.

The sixth transistor T6 includes a gate electrode connected to the Q node, a drain electrode connected to the QB node, and a source electrode connected to the input terminal of the low potential voltage VSS. The sixth transistor T6 discharges the QB node to the low potential voltage VSS in response to the voltage of the QB node.

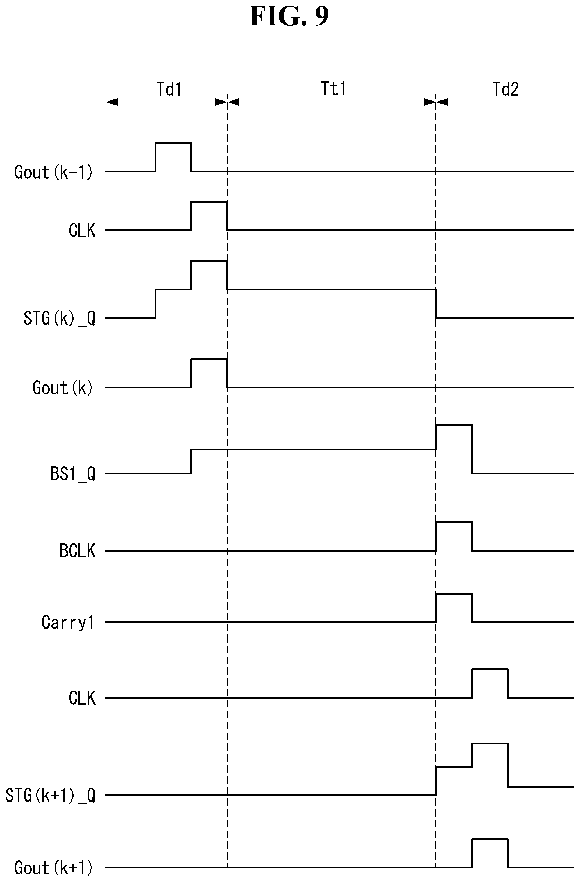

FIG. 9 is a timing diagram illustrating changes in voltages of driving signals and a main node of a bridge stage.

An operation of a bridge stage is described below with reference to FIG. 9.

Before a first display period Td1 ends, a k-th stage STG(k) outputs a k-th gate pulse Gout(k). The k-th gate pulse Gout(k) is applied to a gate electrode of a first transistor T1 included in a first bridge stage BS1.

The first transistor T1 of the first bridge stage BS1 pre-charges the Q node to the high potential voltage VDD in response to the k-th gate pulse Gout(k).

During a first touch sensing period Tt1, the Q node maintains a pre-charged state.

When a second display period Td2 starts after the first touch sensing period Tt1 ends, a drain electrode of a pull-up transistor Tpu of the first bridge stage BS1 receives a bridge clock BCLK. The Q node, which is a gate electrode of the pull-up transistor Tpu, is bootstrapped due to the bridge clock BCLK. When a gate-to-source voltage of the pull-up transistor Tpu reaches a threshold voltage Vth in a process for bootstrapping the Q node, the pull-up transistor Tpu is turned on. The bridge clock BCLK is applied before a (k+1)th gate pulse Gout(k+1) is output in the second display period Td2. The pull-up transistor Tpu of the first bridge stage BS1 outputs a first carry signal Carry1 through an output terminal Nout.

The first carry signal Carry1 is applied to a start control transistor Tvst of a (k+1)th stage STG(k+1). The start control transistor Tvst of the (k+1)th stage STG(k+1) pre-charges a Q1 node in response to the first carry signal Carry1. The (k+1)th stage STG(k+1), in which the Q1 node is pre-charged, charges an output terminal Nout G using a gate clock CLK applied to a pull-up transistor Tpu G and outputs the (k+1)th gate pulse Gout(k+1).

As described above, the shift register according to the embodiment includes a bridge stage for charging a Q node of a stage, which outputs a first gate pulse after the touch sensing period Tt ends. As a result, the embodiment can solve the problem that the gate pulse Gout is not output smoothly because a Q node of a first stage of the panel block is discharged during the touch sensing period Tt.

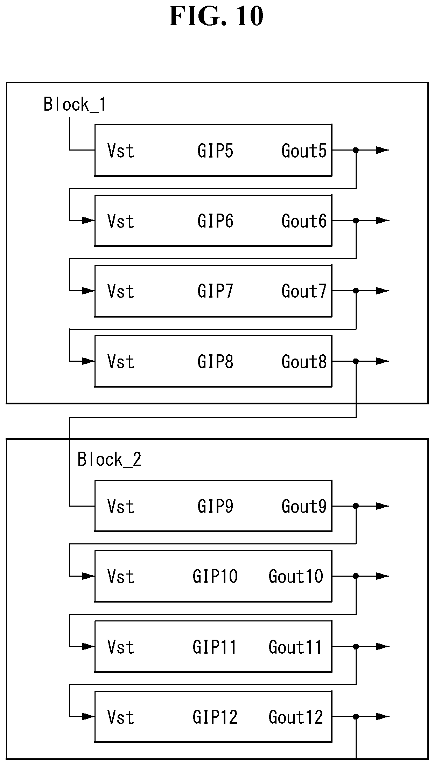

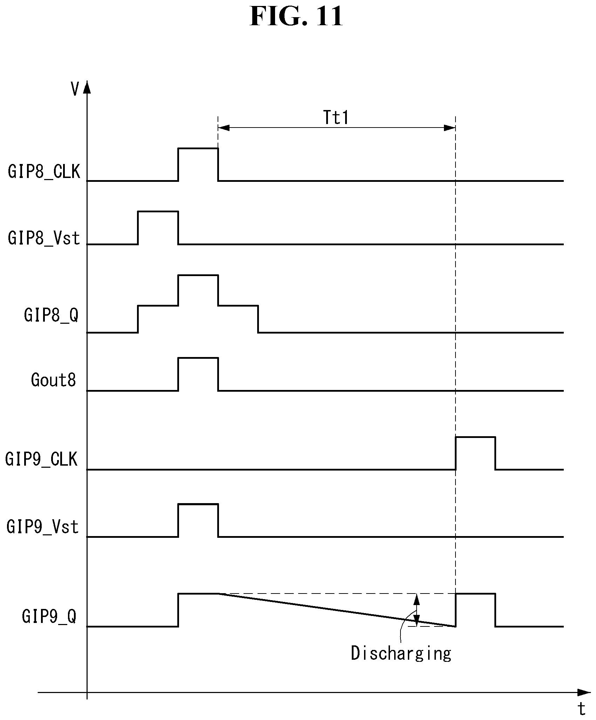

FIG. 10 illustrates configuration of a shift register according to a comparative example. FIG. 11 is a timing diagram illustrating output signals of the shift register shown in FIG. 10. Each stage GIP shown in FIG. 10 may be implemented with the same circuit as the stages of the stage group according to the first example.

Referring to FIGS. 10 and 11, stages according to a comparative example receive an output of a preceding stage as a start signal Vst and output a gate pulse. A first touch sensing period Tt1 exists between a period, in which a first stage group Block_1 is driven, and a period, in which a second stage group Block_2 is driven.

A ninth stage GIP9 receives an output of an eighth stage GIP8 as a start signal GIP VST and charges a Q node GIP9_Q. The ninth stage GIP9 outputs a ninth gate pulse Gout9 when a gate clock GIP9_CLK is input. The ninth stage GIP9 receives a gate clock GIP9 CLK at a time point when a first touch sensing period Tt1 has elapsed since the Q node GIP9_Q was charged. As a result, the Q node GIP9_Q of the ninth stage GIP9 is discharged during the first touch sensing period Tt1, and the bootstrapping is not performed smoothly even if the gate clock GIP9_CLK is input. In addition, the ninth stage GIP9 cannot output the ninth gate pulse Gout9.

On the other hand, in the display device according to the first example, a first stage (e.g., STG(k+1)) of the panel block operates using a first carry signal output by a first bridge stage BS1 after the touch sensing period Tt ends. Thus, the configuration of the first example can improve a phenomenon in which the gate pulse is not output smoothly because the Q node of the first stage of the panel block is discharged during the touch sensing period Tt.

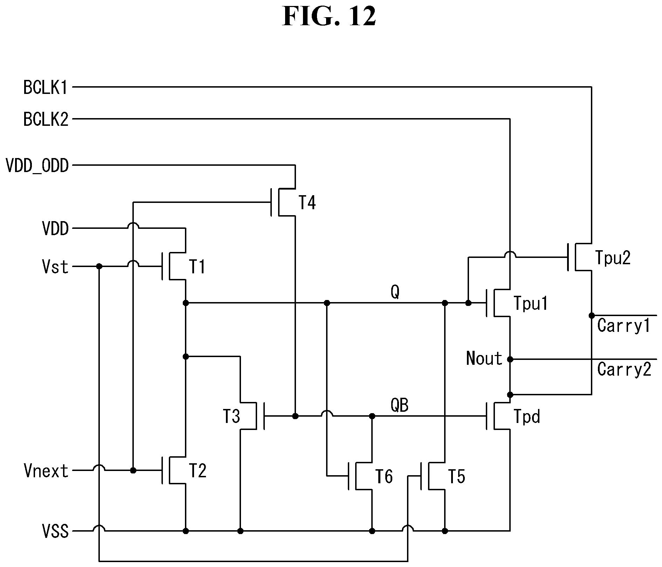

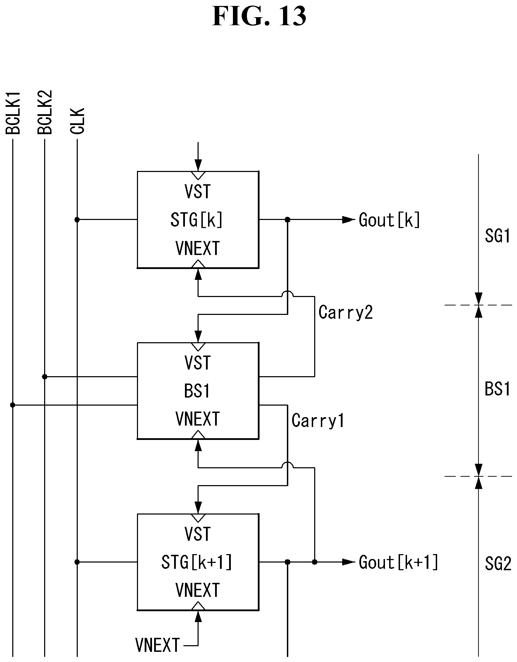

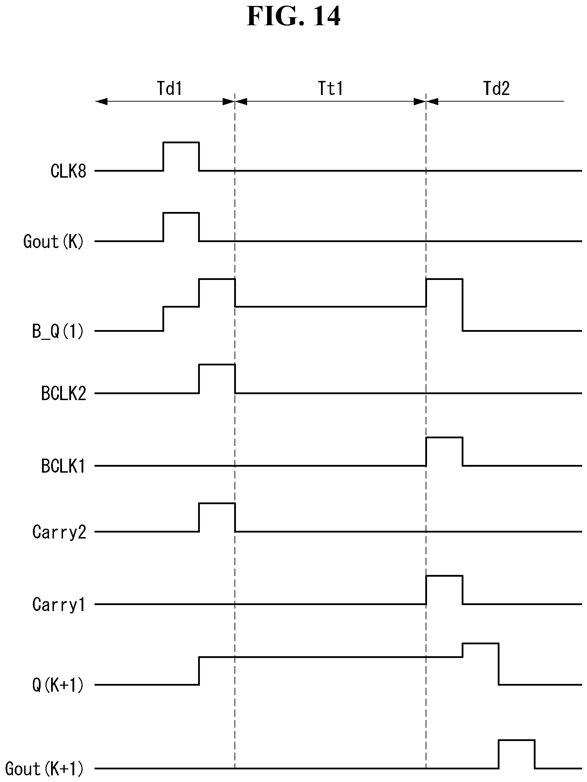

FIG. 12 illustrates a bridge stage according to a first embodiment of the invention. FIG. 13 illustrates a preceding stage and a subsequent stage of a bridge stage. FIG. 14 is a timing diagram illustrating driving signals and a voltage of a main node of the bridge stage according to the first embodiment. The shift register according to the first embodiment has substantially the same configuration as the shift register according to the first example and outputs gate pulses through the same operation as the first example. Thus, a detailed description of the configuration and the operation of the shift register according to the first embodiment will be omitted below.

The stage shown in FIG. 12 is limited to a bridge stage. Namely, a circuit configuration of stages for applying a gate pulse to a panel block is described based on the stage shown in FIG. 8.

The bridge stage according to the first embodiment and an operation thereof are described with reference to FIGS. 12 to 14.

The bridge stage BS according to the first embodiment includes first and second pull-up transistors Tpu1 and Tpu2, a pull-down transistor Tpd, and first to sixth transistors T1 to T6.

The first pull-up transistor Tpu1 includes a gate electrode connected to a Q node, a drain electrode receiving a first bridge clock BCLK1, and a source electrode connected to a first output terminal Nout1. As a result, the first pull-up transistor Tpu1 outputs a first carry signal Carry1 in response to a voltage of the Q node during an application of the first bridge clock BCLK1.

The second pull-up transistor Tpu2 includes a gate electrode connected to the Q node, a drain electrode receiving a second bridge clock BCLK2, and a source electrode connected to a second output terminal Nout2. As a result, the second pull-up transistor Tpu2 outputs a second carry signal Carry2 in response to the voltage of the Q node during an application of the second bridge clock BCLK2.

Before a first display period Td1 ends, a k-th stage STG[k] outputs a k-th gate pulse Gout[k]. The k-th gate pulse Gout[k] is applied to a gate electrode of a first transistor T1 included in a first bridge stage BS1.

The first transistor T1 of the first bridge stage BS1 pre-charges the Q node to a high potential voltage VDD in response to the k-th gate pulse Gout[k].

After the k-th gate pulse Gout[k] ends in the first display period Td1, a drain electrode of the pull-up transistor Tpu receives the bridge clock BCLK2. The Q node, which is a gate electrode of the pull-up transistor Tpu, is bootstrapped due to the bridge clock BCLK. When a gate-to-source voltage of the pull-up transistor Tpu reaches a threshold voltage Vth in a process for bootstrapping the Q node, the pull-up transistor Tpu is turned on. As a result, the second pull-up transistor Tpu2 of the first bridge stage BS1 outputs the second carry signal Carry2 through the second output terminal Nout2.

The second carry signal Carry2 is applied to a Q node control transistor Tn included in a preceding stage, for example, the k-th stage STG[k]. The Q node control transistor Tn of the k-th stage STG[k] discharges the Q node in response to the second carry signal Carry2. As a result, a pull-down transistor Tpd G of a last stage (for example, the k-th stage STG[k]) of the panel block maintains a turn-off state.

In the above-described first example, because the pull-up transistor Tpu disposed at the last stage of the panel block PB receives the high potential voltage during the touch sensing period Tt1, the deterioration is accelerated.

On the other hand, the bridge stage BS according to the first embodiment discharges a Q node of a preceding stage using the second carry signal Carry2 output before the touch sensing period Tt. As a result, in the first embodiment, because the pull-up transistor Tpu disposed at the last stage of the panel block BP receives the low potential voltage during the touch sensing period Tt, the acceleration of the deterioration can be prevented or reduced.

The first bridge clock BCLK1 is applied before a (k+1)th gate pulse Gout[k+1] is output in the second display period Td2. The first pull-up transistor Tpu1 of the first bridge stage BS1 outputs the first carry signal Carry1 through the first output terminal Nout1.

The first carry signal Carry1 is applied to a first transistor T1 of a subsequent stage, for example, a (k+1)th stage STG[k+1]. The first transistor T1 of the (k+1)th stage STG[k+1] pre-charges the Q node in response to the first carry signal Carry1. The (k+1)th stage STG[k+1], in which the Q node is pre-charged, charges the output terminal Nout using the gate clock CLK applied to the pull-up transistor Tpu and outputs the (k+1)th gate pulse Gout[k+1].

It should be understood that numerous embodiments can be devised by those skilled in the art that will fall within the scope of the present claims. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

## Claims

1. Shift register (140) for a display panel comprising a touch sensing circuit, the shift register comprising a first stage group (SG1) comprising a last stage (STG(k)), wherein the last stage (STG(k)) is configured for transmitting a gate pulse (Gout(k)) to a Kth gate line (GL(K)) of the display panel in response to the potential of a Q node of the last stage (STG(k)) and to a gate clock (CLK); a bridge stage (BS1) configured for receiving the gate pulse (Gout(k)) from the last stage (STG(k)), and transmitting a first carry signal (Carry1) and a second carry signal (Carry2); and
a second stage group (SG2) comprising a first stage (STG(k+1)), wherein the first stage is configured for receiving the first carry signal (Carry1), and transmitting a gate pulse (Gout(k+1)) to a (K+1)th gate line (GL(K+1)) of the display panel, which is adjacent to the Kth gate line, in response to the potential of a Q node of the first stage (STG(k+1)) and to the gate clock (CLK);
wherein the bridge stage (BS1) comprises:
a first pull-up transistor (Tpu1) configured to output the first carry signal (Carry1) to the first stage (STG(k+1)),
a second pull-up transistor (Tpu2) configured to output the second carry signal (Carry2) to the last stage (STG(k)),
a pull-down transistor (Tpd),
a first transistor (T1),
a third transistor (T3),
a fifth transistor (T5),
a sixth transistor (T6);
wherein a drain electrode of the first transistor (T1) is connected to a high potential voltage (VDD);
wherein a source electrode of the first transistor (T1) is connected to a Q node (Q)of the bridge stage;
wherein a gate electrode of the first transistor (T1) is connected to a start signal input terminal (Vst) configured to receive the gate pulse (Gout(k)) from the last stage (STG(k));
wherein a drain electrode of the third transistor (T3) is connected to the Q node (Q);
wherein a source electrode of the third transistor (T3) is connected to a low potential voltage (VSS);
wherein a gate electrode of the third transistor (T3) is connected to a drain of the sixth transistor (T6);
wherein a source of the fifth transistor (T5) is connected to the low potential voltage (VSS);
wherein a gate of the fifth transistor (T5) is connected to the start signal input terminal (Vst);
wherein a source of the sixth transistor (T6) is connected to the low potential voltage (VSS);
wherein a gate of the sixth transistor (T6) is connected to the Q node (Q);
wherein a drain of the first pull-up transistor (Tpu1) is connected to a first bridge clock (BCLK1);
wherein a source of the first pull-up transistor (Tpu1) is connected to a drain of the pull-down transistor (Tpd);
wherein a gate of the first pull-up transistor (Tpu1) is connected to the Q node (Q);
wherein a source of the pull-down (Tpd) transistor is connected to the low potential voltage (VSS);
wherein the gate of the pull-down transistor (Tpd) is connected to the gate of the third transistor (T3);
wherein the drain of the fifth transistor (T5) is connected to the Q node (Q);
wherein the drain of the second pull-up transistor (Tpu2) is connected to a second bridge clock (BCLK2);
wherein the source of the second pull-up transistor (Tpu2) is connected to the drain of the pull-down transistor (Tpd); and
wherein the gate of the second pull-up transistor (Tpu2) is connected to the Q node (Q);
wherein the last stage (STG(K) of the first stage group (SG1) is configured for discharging its Q node in response to the second carry signal (Carry2), and
the first stage (STG(K+1)) of the second stage group (SG2) is configured for pre-charging its Q node in response to the first carry signal (Carry1).

2. Shift register (120) according to claim 1, wherein the bridge stage (BS1) is configured for charging the Q node (Q) of the bridge stage (BS1) in response to the gate pulse (Gout(k)) from the last stage (STG(k)) and transmitting the first carry signal (carry1) in response to the potential of the Q node and the first bridge clock (BCLK1).

3. Shift register (120) according to claim 2, wherein the bridge stage (BS1) is configured for receiving the gate pulse (Gout(k+1) from the first stage (STG(k+1)) and discharging the Q node of the bridge stage (BS1) in response to the gate pulse (Gout(k+1)) from the first stage (STG(k+1)).

4. Shift register (120) according to claim 2 or 3,
wherein at least one of the last stage (STG(k)) of the first stage group (SG1) and the first stage (STG(k+1)) of the second stage group (SG2) comprises
a pull-up transistor (Tpu_G), a pull-down transistor (Tpd_G), a first transistor (Tvst), a third transistor (T3),
a fifth transistor (T5), and
a sixth transistor (T6);
wherein a drain electrode of the first transistor (Tvst) is connected to the high potential voltage (VDD);
wherein a source electrode of the first transistor (Tvst) is connected to the Q node of the stage;
wherein a gate electrode of the first transistor (Tvst) is connected to a start input terminal (Vst) of the stage;
wherein a drain electrode of the third transistor (T3) is connected to the Q node;
wherein a source electrode of the third transistor (T3) is connected to the low potential voltage (VSS);
wherein a gate electrode of the third transistor (T3) is connected to a source of the fifth transistor (T5);
wherein a source of the fifth transistor (T5) is connected to the low potential voltage (VSS);
wherein a gate of the fifth transistor (T5) is connected to the start input terminal (Vst) of the stage; wherein a drain of the sixth transistor (T6) is connected to the gate of third transistor (T3); wherein a source of the sixth transistor (T6) is connected to the low potential voltage (VSS); wherein a gate of the sixth transistor (T6) is connected to the drain of the first transistor (Tvst); wherein a drain of the pull-up transistor (Tpu_G) is connected to the gate clock (CLK); wherein a source of the pull-up transistor (Tpu_G) is connected to a source of the pull-down transistor (Tpd_G) wherein a gate of the pull-up transistor (Tpu_G) is connected to the Q node; wherein the source of the pull-down (Tpd_G) transistor is connected to the low potential voltage (VSS);
wherein the gate of the pull-down transistor (Tpd_G) is connected to the gate of the third transistor (T3); and
wherein the drain of the fifth transistor (T5) is connected to the gate of the third transistor (T3).

5. Shift register according to claim 4,
wherein the last stage (STG(k)) of the first stage group (SG1) or the first stage (STG(k+1)) of the second stage group (SG2) comprises
a second transistor (Tn), a fourth transistor (T4);
wherein a source of the second transistor (Tn) is connected to the Q node of the stage;
wherein a drain of the second transistor (Tn) is connected to a low potential voltage (VSS); wherein a gate of the second transistor (Tn) is connected to a next input terminal (Vnext) of the stage;
wherein a source of the fourth transistor (T4) is connected to the gate of the third transistor (T3);
wherein a drain of the fourth transistor (T4) is connected to the high potential voltage (VDD);
wherein a gate of the fourth transistor (T4) is connected to the next input terminal (Vnext).

6. Shift register according to claim 1,
wherein the bridge stage (BS1) further comprises
a second transistor (T2),
a fourth transistor (T4);
wherein a source of the second transistor (T2) is connected to the Q node;
wherein a drain of the second transistor (T2) is connected to the low potential voltage (VSS);
wherein a gate of the second transistor (T2) is connected to a next input terminal (Vnext) of the stage; wherein a source of the fourth transistor (T4) is connected to the gate of the third transistor (T3);
wherein a drain of the fourth transistor (T4) is connected to a second high potential voltage (VDD ODD); and
wherein a gate of the fourth transistor (T4) is connected to the next input terminal (Vnext).

7. Gate driver comprising
a shift register (140) according to any one of claims 1 to 6, and
a level shifter (130) for shifting transistor-transistor-logic, TTL, voltages of gate clocks to a gate high voltage (VGH) and a gate low voltage (VGL).

8. Display panel (100) comprising
a display unit (100A) including a plurality of pixels (P) and at least one touch sensor (TC),
a gate driver according to claim 7 for transmitting gate pulses to gate lines of the display unit, and
a touch sensing circuit (150).

9. Display panel (100) according to claim 8,
wherein the touch sensor (TC) is formed by a common electrode (7) of a group of the plurality of pixels (P).

10. Method for driving the display panel of claim 8 or 9, comprising:
receiving the gate pulse (Gout(k)) by the bridge stage (BS1) from the last stage (STG(k));
sensing a touch by the touch sensing circuit (150) after receiving the gate pulse (Gout(k)) by the bridge stage (BS1); transmitting the second carry signal (Carry2) from the bridge stage (BS1) to the last stage (STG(k)) after receiving the gate pulse (Gout(k)) by the bridge stage (BS1) and before sensing the touch; and
transmitting the first carry signal (Carry1) from the bridge stage (BS1) to the first stage (STG(k+1)) after sensing the touch.

11. Method according to claim 10, wherein the method further comprises charging the Q node of the bridge stage (BS1) in response to the gate pulse (Gout(k)) and transmitting the first carry signal (Carry1) in response to the potential of the Q node and the first bridge clock.

12. Method according to claim 11, wherein the method further comprises discharging the Q node of the bridge stage (BS1) in response to the gate pulse (Gout(k+1) received from the first stage (STG(k+1).

13. Method according to any one of claims 10 to 12, wherein sensing the touch by the touch sensing circuit (150) comprises using touch sensors (TC) formed by a common electrode (7) of a group of pixels of a display unit of the display panel.

14. Method according to any one of claims 10 to 13, wherein a shift register according to any one of claims 1 to 6 is used.

## Patentansprüche

1. Schieberegister (140) für eine Anzeigetafel, die eine Berührungserfassungsschaltung umfasst, wobei das Schieberegister Folgendes umfasst:
eine erste Stufengruppe (SG1), die eine letzte Stufe (STG(k)) umfasst, wobei die letzte Stufe (STG(k)) konfiguriert ist zum:
Senden eines Gate-Impulses (Gout(k)) an eine K-te Gate-Leitung (GL(K)) der Anzeigetafel als Reaktion auf das Potenzial eines Q-Knotens der letzten Stufe (STG(k)) und einen Gate-Takt (CLK);
eine Brückenstufe (BS1), die konfiguriert ist zum
Empfangen des Gate-Impulses (Gout(k)) von der letzten Stufe (STG(k)) und
Senden eines ersten Trägersignals (Carry1) und eines zweiten Trägersignals (Carry2); und
eine zweite Stufengruppe (SG2), die eine erste Stufe (STG(k+1)) umfasst, wobei die erste Stufe konfiguriert ist zum
Empfangen des ersten Trägersignals (Carry1) und Senden eines Gate-Impulses (Gout(k+1)) an eine (K+1)-te Gate-Leitung (GL(K+1)) der Anzeigetafel, die an die K-te Gate-Leitung angrenzt, als Reaktion auf das Potenzial eines Q-Knotens der ersten Stufe (STG(k+1)) und den Gate-Takt (CLK);
wobei die Brückenstufe (BS1) umfasst:
einen ersten Pull-up-Transistor (Tpu1), der konfiguriert ist, das erste Trägersignal (Carry1) an die erste Stufe (STG(k+1)) auszugeben,
einen zweiten Pull-up-Transistor (Tpu2), der konfiguriert ist, das zweite Trägersignals (Carry2) an die letzte Stufe (STG(k)) auszugeben,
einen Pull-down-Transistor (Tpd),
einen ersten Transistor (T1),
einen dritten Transistor (T3),
einen fünften Transistor (T5),
einen sechsten Transistor (T6);
wobei eine Drain-Elektrode des ersten Transistors (T1) mit einer Hochpotenzialspannung (VDD) verbunden ist;
wobei eine Source-Elektrode des ersten Transistors (T1) mit einem Q-Knoten (Q) der Brückenstufe verbunden ist;
wobei eine Gate-Elektrode des ersten Transistors (T1) mit einem Startsignaleingangsanschluss (Vst) verbunden ist, der konfiguriert ist, den Gate-Impuls (Gout(k)) von der letzten Stufe (STG(k)) zu empfangen;
wobei eine Drain-Elektrode des dritten Transistors (T3) mit dem Q-Knoten (Q) verbunden ist;
wobei eine Source-Elektrode des dritten Transistors (T3) mit einer Niederpotenzialspannung (VSS) verbunden ist;
wobei eine Gate-Elektrode des dritten Transistors (T3) mit einem Drain des sechsten Transistors (T6) verbunden ist;
wobei eine Source des fünften Transistors (T5) mit der Niederpotenzialspannung (VSS) verbunden ist;
wobei ein Gate des fünften Transistors (T5) mit dem Startsignaleingangsanschluss (Vst) verbunden ist;
wobei eine Source des sechsten Transistors (T6) mit der Niederpotenzialspannung (VSS) verbunden ist;
wobei ein Gate des sechsten Transistors (T6) mit dem Q-Knoten (Q) verbunden ist;
wobei ein Drain des ersten Pull-up-Transistors (Tpu1) mit einem ersten Brückentakt (BCLK1) verbunden ist;
wobei eine Source des ersten Pull-up-Transistors (Tpu1) mit einem Drain des Pull-down-Transistors (Tpd) verbunden ist;
wobei ein Gate des ersten Pull-up-Transistors (Tpu1) mit dem Q-Knoten (Q) verbunden ist;
wobei eine Source des Pull-down-Transistors (Tpd) mit der Niederpotenzialspannung (VSS) verbunden ist;
wobei das Gate des Pull-down-Transistors (Tpd) mit dem Gate des dritten Transistors (T3) verbunden ist;
wobei der Drain des fünften Transistors (T5) mit dem Q-Knoten (Q) verbunden ist;
wobei der Drain des zweiten Pull-up-Transistors (Tpu2) mit einem zweiten Brückentakt (BCLK2) verbunden ist;
wobei die Source des zweiten Pull-up-Transistors (Tpu2) mit dem Drain des Pull-down-Transistors (Tpd) verbunden ist; und
wobei das Gate des zweiten Pull-up-Transistors (Tpu2) mit dem Q-Knoten (Q) verbunden ist;
wobei die letzte Stufe (STG(K) der ersten Stufengruppe (SG1) konfiguriert ist, ihren Q-Knoten als Reaktion auf das zweite Trägersignal (Carry2) zu entladen, und
die erste Stufe (STG(K+1)) der zweiten Stufengruppe (SG2) konfiguriert ist, ihren Q-Knoten als Reaktion auf das erste Trägersignal (Carry1) vorzuladen.

2. Schieberegister (120) nach Anspruch 1,
wobei die Brückenstufe (BS1) konfiguriert ist, den Q-Knoten (Q) der Brückenstufe (BS1) als Reaktion auf den Gate-Impuls (Gout(k)) von der letzten Stufe (STG(k)) zu laden und das erste Trägersignal (carry1) als Reaktion auf das Potenzial des Q-Knotens und den ersten Brückentakt (BCLK1) zu senden.

3. Schieberegister (120) nach Anspruch 2, wobei
die Brückenstufe (BS1) konfiguriert ist zum
Empfangen des Gate-Impulses (Gout(k+1)) von der ersten Stufe (STG(k+1)) und
Entladen des Q-Knotens der Brückenstufe (BS1) als Reaktion auf den Gate-Impuls (Gout(k+1)) von der ersten Stufe (STG(k+1)).

4. Schieberegister (120) nach Anspruch 2 oder 3,
wobei die letzte Stufe (STG(k)) der ersten Stufengruppe (SG1) und/oder die erste Stufe (STG(k+1)) der zweite Stufengruppe (SG2) umfasst:
einen Pull-up-Transistor (Tpu G),
einen Pull-down-Transistor (Tpd_G),
einen ersten Transistor (Tvst),
einen dritten Transistor (T3),
einen fünften Transistor (T5) und
einen sechsten Transistor (T6);
wobei eine Drain-Elektrode des ersten Transistors (Tvst) mit der Hochpotenzialspannung (VDD) verbunden ist;
wobei eine Source-Elektrode des ersten Transistors (Tvst) mit dem Q-Knoten (Q) der Stufe verbunden ist;
wobei eine Gate-Elektrode des ersten Transistors (Tvst) mit einem Starteingangsanschluss (Vst) der Stufe verbunden ist;
wobei eine Drain-Elektrode des dritten Transistors (T3) mit dem Q-Knoten (Q) verbunden ist;
wobei eine Source-Elektrode des dritten Transistors (T3) mit der Niederpotenzialspannung (VSS) verbunden ist;
wobei eine Gate-Elektrode des dritten Transistors (T3) mit einer Source des fünften Transistors (T5) verbunden ist;
wobei eine Source des fünften Transistors (T5) mit der Niederpotenzialspannung (VSS) verbunden ist;
wobei ein Gate des fünften Transistors (T5) mit dem Starteingangsanschluss (Vst) der Stufe verbunden ist;
wobei ein Drain des sechsten Transistors (T6) mit dem Gate des dritten Transistors (T3) verbunden ist;
wobei eine Source des sechsten Transistors (T6) mit der Niederpotenzialspannung (VSS) verbunden ist;
wobei ein Gate des sechsten Transistors (T6) mit dem Drain des ersten Transistors (Tvst) verbunden ist;
wobei ein Drain des Pull-up-Transistors (Tpu_G) mit dem Gate-Takt (CLK) verbunden ist;
wobei eine Source des Pull-up-Transistors (Tpu G) mit einer Source des Pull-down-Transistors (Tpd_G) verbunden ist;
wobei ein Gate des Pull-up-Transistors (Tpu_G) mit dem Q-Knoten verbunden ist;
wobei die Source des Pull-down-Transistors (Tpd G) mit der Niederpotenzialspannung (VSS) verbunden ist;
wobei das Gate des Pull-down-Transistors (Tpd_G) mit dem Gate des dritten Transistors (T3) verbunden ist; und
wobei der Drain des fünften Transistors (T5) mit dem Gate des dritten Transistors (T3) verbunden ist.

5. Schieberegister nach Anspruch 4,
wobei die letzte Stufe (STG(k)) der ersten Stufengruppe (SG1) oder die erste Stufe (STG(k+1)) der zweiten Stufengruppe (SG2) umfasst:
einen zweiten Transistor (Tn);
einen vierten Transistor (T4);
wobei eine Source des zweiten Transistors (Tn) mit dem Q-Knoten der Stufe verbunden ist;
wobei ein Drain des zweiten Transistors (Tn) mit einer Niederpotenzialspannung (VSS) verbunden ist;
wobei ein Gate des zweiten Transistors (Tn) mit einem nächsten Eingangsanschluss (Vnext) der Stufe verbunden ist;
wobei eine Source des vierten Transistors (T4) mit dem Gate des dritten Transistors (T3) verbunden ist;
wobei ein Drain des vierten Transistors (T4) mit der Hochpotenzialspannung (VDD) verbunden ist;
wobei ein Gate des vierten Transistors (T4) mit dem nächsten Eingangsanschluss (Vnext) verbunden ist.

6. Schieberegister nach Anspruch 1,
wobei die Brückenstufe (BS1) ferner umfasst:
einen zweiten Transistor (T2),
einen vierten Transistor (T4),
wobei eine Source des zweiten Transistors (T2) mit dem Q-Knoten verbunden ist;
wobei ein Drain des zweiten Transistors (T2) mit der Niederpotenzialspannung (VSS) verbunden ist;
wobei ein Gate des zweiten Transistors (T2) mit einem nächsten Eingangsanschluss (Vnext) der Stufe verbunden ist;
wobei eine Source des vierten Transistors (T4) mit dem Gate des dritten Transistors (T3) verbunden ist;
wobei ein Drain des vierten Transistors (T4) mit einer zweiten Hochpotenzialspannung (VDD_ODD) verbunden ist; und
wobei ein Gate des vierten Transistors (T4) mit dem nächsten Eingangsanschluss (Vnext) verbunden ist.

7. Gate-Treiber, der umfasst:
ein Schieberegister (140) nach einem der Ansprüche 1 bis 6 und
einen Pegelschieber (130) zum Schieben von Transistor-Transistor-Logik-Spannungen, TTL-Spannungen, von Gate-Takten zu einer Gate-Hochspannung (VGH) und einer Gate-Niederspannung (VGL).

8. Anzeigetafel (100), die umfasst:
eine Anzeigeeinheit (100A), die mehrere Pixel (P) und mindestens einen Berührungssensor (TC) enthält,
einen Gate-Driver nach Anspruch 7 zum Senden von Gate-Impulsen an Gate-Leitungen auf der Anzeigeeinheit und
eine Berührungserfassungsschaltung (150).

9. Anzeigetafel (100) nach Anspruch 8,
wobei der Berührungssensor (TC) durch eine gemeinsame Elektrode (7) einer Gruppe der mehreren Pixel (P) gebildet ist.

10. Verfahren zum Ansteuern der Anzeigetafel nach Anspruch 8 oder 9, das umfasst:
Empfangen des Gate-Impulses (Gout(k)) durch die Brückenstufe (BS1) von der letzten Stufe (STG(k));
Erfassen einer Berührung durch die Berührungserfassungsschaltung (150) nach dem Empfangen des Gate-Impulses (Gout(K)) durch die Brückenstufe (BS1); Senden des zweiten Trägersignals (Carry2) von der Brückenstufe (BS1) an die letzte Stufe (STG(k)) nach dem Empfangen des Gate-Impulses (Gout(k)) durch die Brückenstufe (BS1) und vor dem Erfassen der Berührung; und
Senden des ersten Trägersignals (Carry1) von der Brückenstufe (BS1) an die erste Stufe (STG(k+1)) nach dem Erfassen der Berührung.

11. Verfahren nach Anspruch 10, wobei das Verfahren ferner umfasst:
Laden des Q-Knotens der Brückenstufe (BS1) als Reaktion auf den Gate-Impuls (Gout(k)) und Senden des ersten Trägersignals (Carry1) als Reaktion auf das Potenzial des Q-Knotens und des ersten Brückentakts.

12. Verfahren nach Anspruch 11, wobei das Verfahren ferner umfasst:
Entladen des Q-Knotens der Brückenstufe (BS1) als Reaktion auf den Gate-Impuls (Gout(k+1)), der von der ersten Stufe (STG(k+1)) empfangen wird.

13. Verfahren nach einem der Ansprüche 10 bis 12, wobei das Erfassen der Berührung durch die Berührungserfassungsschaltung (150) umfasst, Berührungssensoren (TC) zu verwenden, die durch eine gemeinsame Elektrode (7) einer Gruppe von Pixeln einer Anzeigeeinheit der Anzeigetafel gebildet werden.

14. Verfahren nach einem der Ansprüche 10 bis 13, wobei ein Schieberegister nach einem der Ansprüche 1 bis 6 verwendet wird.

## Revendications

1. Registre à décalage (140) pour un panneau d'affichage comprenant un circuit de détection d'effleurement, le registre à décalage comprenant
un premier groupe d'étages (SG1) comprenant un dernier étage (STG(k)), dans lequel le dernier étage (STG(k)) est configuré pour transmettre une impulsion de grille (Gout(k)) à une k-ème ligne de grille (GL(K)) du panneau d'affichage en réponse au potentiel d'un noeud Q du dernier étage (STG(k)) et à une impulsion d'horloge de grille (CLK) ;
un étage de pont (BS1) configuré pour
recevoir l'impulsion de grille (Gout(k)) du dernier étage (STG(k)), et
transmettre un premier signal de report (Carry1) et un deuxième signal de report (Carry2) ; et
un deuxième groupe d'étages (SG2) comprenant un premier étage (STG(k+1)), dans lequel le premier étage est configuré pour
recevoir le premier signal de report (Carry1) et transmettre une impulsion de grille (Gout(k+1)) à une (K+1)ème ligne de grille (GL(K+1)) du panneau d'affichage, laquelle est adjacente à la K-ème ligne de grille, en réponse au potentiel d'un noeud Q du premier étage (STG(k+1)) et à l'impulsion d'horloge de grille (CLK) ;
dans lequel l'étage de pont (BS1) comprend :
un premier transistor de tirage vers le haut (Tpu1) configuré pour faire sortir le premier signal de report (Carry1) à l'attention du premier étage (STG(k+1)),
un deuxième transistor de tirage vers le haut (Tpu2) configuré pour faire sortir le deuxième signal de report (Carry2) à l'attention du dernier étage (STG(k)),
un transistor de tirage vers le bas (Tpd),
un premier transistor (T1),
un troisième transistor (T3),
un cinquième transistor (T5),
un sixième transistor (T6) ;
dans lequel une électrode de drain du premier transistor (T1) est connectée à une tension de potentiel élevé (VDD) ;
dans lequel une électrode de source du premier transistor (T1) est connectée à un noeud Q (Q) de l'étage de pont ;
dans lequel une électrode de grille du premier transistor (T1) est connectée à une borne d'entrée de signal de démarrage (Vst) configurée pour recevoir l'impulsion de grille (Gout(k)) du dernier étage (STG(k)) ;
dans lequel une électrode de drain du troisième transistor (T3) est connectée au noeud Q (Q) ;
dans lequel une électrode de source du troisième transistor (T3) est connectée à une tension de potentiel bas (VSS) ;
dans lequel une électrode de grille du troisième transistor (T3) est connectée à un drain du sixième transistor (T6) ;
dans lequel une source du cinquième transistor (T5) est connectée à la tension de potentiel bas (VSS) ;
dans lequel une grille du cinquième transistor (T5) est connectée à la borne d'entrée de signal de démarrage (Vst) ;
dans lequel une source du sixième transistor (T6) est connectée à la tension de potentiel bas (VSS) ;
dans lequel une grille du sixième transistor (T6) est connectée au noeud Q (Q) ;
dans lequel un drain du premier transistor de tirage vers le haut (Tpu1) est connecté à une première impulsion d'horloge de pont (BCLK1) ;
dans lequel une source du premier transistor de tirage vers le haut (Tpu1) est connectée à un drain du transistor de tirage vers le bas (Tpd) ;
dans lequel une grille du premier transistor de tirage vers le haut (Tpu1) est connectée au noeud Q (Q) ;
dans lequel une source du transistor de tirage vers le bas (Tpd) est connectée à la tension de potentiel bas (VSS) ;
dans lequel la grille du transistor de tirage vers le bas (Tpd) est connectée à la grille du troisième transistor (T3) ;
dans lequel le drain du cinquième transistor (T5) est connecté au noeud Q (Q) ;
dans lequel le drain du deuxième transistor de tirage vers le haut (Tpu2) est connecté à une deuxième impulsion d'horloge de pont (BCLK2) ;
dans lequel la source du deuxième transistor de tirage vers le haut (Tpu2) est connectée au drain du transistor de tirage vers le bas (Tpd) ; et
dans lequel la grille du deuxième transistor de tirage vers le haut (Tpu2) est connectée au noeud Q (Q) ;
dans lequel le dernier étage (STG(K)) du premier groupe d'étages (SG1) est configuré pour décharger son noeud Q en réponse au deuxième signal de report (Carry2), et
le premier étage (STG(K+1)) du deuxième groupe d'étages (SG2) est configuré pour la pré-charge de son noeud Q en réponse au premier signal de report (Carry1).

2. Registre à décalage (120) selon la revendication 1,
dans lequel l'étage de pont (BS1) est configuré pour charger le noeud Q (Q) de l'étage de pont (BS1) en réponse à l'impulsion de grille (Gout(k)) du dernier étage (STG(k)) et transmettre le premier signal de report (carry1) en réponse au potentiel du noeud Q et à la première impulsion d'horloge de pont (BCLK1).

3. Registre à décalage (120) selon la revendication 2, dans lequel
l'étage de pont (BS1) est configuré pour
recevoir l'impulsion de grille (Gout(k+1)) du premier étage (STG(k+1)) et
décharger le noeud Q de l'étage de pont (BS1) en réponse à l'impulsion de grille (Gout(k+1)) du premier étage (STG(k+1)).

4. Registre à décalage (120) selon la revendication 2 ou 3,
dans lequel au moins l'un parmi le dernier étage (STG(k)) du premier groupe d'étages (SG1) et le premier étage (STG(k+1)) du deuxième groupe d'étages (SG2) comprend
un transistor de tirage vers le haut (Tpu_G),
un transistor de tirage vers le bas (Tpd_G),
un premier transistor (Tvst),
un troisième transistor (T3),
un cinquième transistor (T5), et
un sixième transistor (T6) ;
dans lequel une électrode de drain du premier transistor (Tvst) est connectée à la tension de potentiel élevé (VDD) ;
dans lequel une électrode de source du premier transistor (Tvst) est connectée au noeud Q de l'étage ;
dans lequel une électrode de grille du premier transistor (Tvst) est connectée à une borne d'entrée de démarrage (Vst) de l'étage ;
dans lequel une électrode de drain du troisième transistor (T3) est connectée au noeud Q ;
dans lequel une électrode de source du troisième transistor (T3) est connectée à la tension de potentiel bas (VSS) ;
dans lequel une électrode de grille du troisième transistor (T3) est connectée à une source du cinquième transistor (T5) ;
dans lequel une source du cinquième transistor (T5) est connectée à la tension de potentiel bas (VSS) ;
dans lequel une grille du cinquième transistor (T5) est connectée à la borne d'entrée de démarrage (Vst) de l'étage ;
dans lequel un drain du sixième transistor (T6) est connecté à la grille du troisième transistor (T3) ;
dans lequel une source du sixième transistor (T6) est connectée à la tension de potentiel bas (VSS) ;
dans lequel une grille du sixième transistor (T6) est connectée au drain du premier transistor (Tvst) ;
dans lequel un drain du transistor de tirage vers le haut (Tpu_G) et connecté à l'impulsion d'horloge de grille (CLK) ;
dans lequel une source du transistor de tirage vers le haut (Tpu_G) est connectée à une source du transistor de tirage vers le bas (Tpd_G) ;
dans lequel une grille du transistor de tirage vers le haut (Tpu_G) est connectée au noeud Q ;
dans lequel la source du transistor de tirage vers le base (Tpd_G) est connectée à la tension de potentiel bas (VSS) ;
dans lequel la grille du transistor de tirage vers le bas (Tpd_G) est connectée à la grille du troisième transistor (T3) ; et
dans lequel le drain du cinquième transistor (T5) est connecté à la grille du troisième transistor (T3).

5. Registre à décalage selon la revendication 4,
dans lequel le dernier étage (STG(k)) du premier groupe d'étages (SG1) ou le premier étage (STG(k+1)) du deuxième groupe d'étages (SG2) comprend
un deuxième transistor (Tn),
un quatrième transistor (T4) ;
dans lequel une source du deuxième transistor (Tn) est connectée au noeud Q de l'étage ;
dans lequel un drain du deuxième transistor (Tn) est connecté à une tension de potentiel bas (VSS) ;
dans lequel une grille du deuxième transistor (Tn) est connectée à une borne d'entrée suivante (Vnext) de l'étage ;
dans lequel une source du quatrième transistor (T4) est connectée à la grille du troisième transistor (T3) ;
dans lequel un drain du quatrième transistor (T4) est connecté à la tension de potentiel élevé (VDD) ;
dans lequel une grille du quatrième transistor (T4) est connectée à la borne d'entrée suivante (Vnext).

6. Registre à décalage selon la revendication 1,
dans lequel l'étage de pont (BS1) comprend en outre
un deuxième transistor (T2),
un quatrième transistor (T4) ;
dans lequel une source du deuxième transistor (T2) est connectée au noeud Q ;
dans lequel un drain du deuxième transistor (T2) est connecté à la tension de potentiel bas (VSS) ;
dans lequel une grille du deuxième transistor (T2) est connectée à une borne d'entrée suivante (Vnext) de l'étage ;
dans lequel une source du quatrième transistor (T4) est connectée à la grille du troisième transistor (T3) ;
dans lequel un drain du quatrième transistor (T4) est connecté à une deuxième tension de potentiel élevé (VDD_ODD) ; et
dans lequel une grille du quatrième transistor (T4) est connectée à la borne d'entrée suivante (Vnext).

7. Circuit d'attaque de grille comprenant :
un registre à décalage (140) selon l'une quelconque des revendications 1 à 6, et
un décaleur de niveau (130) pour décaler des tensions de logique transistor-transistor, TTL, d'impulsions d'horloge de grille à une tension élevée de grille (VGH) et une tension basse de grille (VGL).

8. Panneau d'affichage (100) comprenant
une unité d'affichage (100A) comprenant une pluralité de pixels (P) et au moins un capteur d'effleurement (TC),
un circuit d'attaque de grille selon la revendication 7 pour transmettre des impulsions de grille à des lignes de grille de l'unité d'affichage, et
un circuit de détection d'effleurement (150).

9. Panneau d'affichage (100) selon la revendication 8,
dans lequel le capteur d'effleurement (TC) est formé par une électrode commune (7) d'un groupe de la pluralité de pixels (P).

10. Procédé pour commander du panneau d'affichage selon la revendication 8 ou 9, comprenant :
la réception de l'impulsion de grille (Gout(k)) par l'étage de pont (BS1) du dernier étage (STG(k)) ;
la détection d'un effleurement par le circuit de détection d'effleurement (150) après la réception de l'impulsion de grille (Gout(k)) par l'étage de pont (BS1) ; la transmission du deuxième signal de report (Carry2) de l'étage de pont (BS1) au dernier étage (STG(k)) après la réception de l'impulsion de grille (Gout(k)) par l'étage de pont (BS1) et avant la détection de l'effleurement ; et
la transmission du premier signal de report (Carry1) de l'étage de pont (BS1) au premier étage (STG(k+1)) après la détection de l'effleurement.

11. Procédé selon la revendication 10, dans lequel le procédé comprend en outre
la charge du noeud Q de l'étage de pont (BS1) en réponse à l'impulsion de grille (Gout(k)) et
la transmission du premier signal de report (Carry1) en réponse au potentiel du noeud Q et à la première impulsion d'horloge de pont.

12. Procédé selon la revendication 11, dans lequel le procédé comprend en outre la décharge du noeud Q de l'étage de pont (BS1) en réponse à l'impulsion d'horloge de grille (Gout(k+1)) reçue du premier étage (STG(k+1).

13. Procédé selon l'une quelconque des revendications 10 à 12, dans lequel la détection de l'effleurement par le circuit de détection d'effleurement (150) comprend l'utilisation de capteurs d'effleurement (TC) formés par une électrode commune (7) d'un groupe de pixels d'une unité d'affichage du panneau d'affichage.

14. Procédé selon l'une quelconque des revendications 10 à 13, dans lequel un registre à décalage selon l'une quelconque de revendications 1 à 6 est utilisé.
